# EUROPEAN PATENT APPLICATION

(11) **EP 4 787 425 A1**
(43) Date of publication of application: **05.08.2026**
(21) Application number: 23954325.9
(22) Date of filing: 28.09.2023
(51) Int. Cl.: H01L 21/28

(54) **LASER IRRADIATION DEVICE, LASER IRRADIATION METHOD, AND METHOD FOR MANUFACTURING COMPOUND SEMICONDUCTOR DEVICE**

(71) Applicant: JSW AKTINA SYSTEM CO., LTD., Yokohama-shi, Kanagawa 236-0004 (JP)
(72) Inventor: SATOU Mitsuhiro, Yokohama-shi, Kanagawa 236-0004 (JP); TANAKA Hiroya, Yokohama-shi, Kanagawa 236-0004 (JP)
(74) Representative: Simmons & Simmons LLP (Munich)
(86) International application number: PCT/JP2023/035543
(87) International publication number: WO 2025/069355

(57) **Abstract**

A laser irradiation device (1) according to the present embodiment irradiates a wafer comprising a compound semiconductor with laser light in order to form a rear surface electrode of a semiconductor device formed on the wafer. The laser irradiation device comprises: a stage (110) that holds the wafer (W); a chamber (80) that houses the stage (110) and a laser light source (10) that generates the laser light (L1); a window unit (50) that is provided in the chamber (80) and includes a window (502) through which the laser light passes; and a dust collector (60) that is provided directly below the window unit (50) and is provided with a supply port (603) for supplying a gas and an exhaust port (602) for discharging dust.

## Description

### Technical Field

The present disclosure relates to a laser irradiation apparatus, a laser irradiation method, and a method for manufacturing a compound semiconductor device.

### Background Art

Patent Literature 1 discloses a laser annealing apparatus that uses excimer laser. In Patent Literature 1, a conveyance unit conveys a substrate in a state in which a levitation unit levitates a substrate. Then, the substrate that is being conveyed is irradiated with line-shaped laser light. Further, this laser irradiation apparatus includes a line sensor that is provided on the substrate. The line sensor images the substrate that is being conveyed.

### Citation List

### Patent Literature

[Patent Literature 1] Japanese Unexamined Patent Application Publication No. 2018-64048

### Summary of Invention

### Technical Problem

It is desired, in the above apparatus, that laser light is appropriately irradiated.

The other problems of the related art and the novel characteristics of the present invention will be made apparent from the descriptions of the specification and the accompanying drawings.

### Solution to Problem

According to one embodiment, a laser irradiation apparatus is a laser irradiation apparatus configured to perform irradiation of laser light in order to form a back electrode of a semiconductor device formed on a wafer formed of a compound semiconductor, the laser irradiation apparatus including: a stage configured to hold the wafer; a laser light source configured to generate the laser light; a chamber configured to accommodate the stage; a window unit that is provided in the chamber and includes a window through which the laser light transmits; and a dust collector that is disposed immediately below the window unit and is provided with a supply port configured to supply gas toward the wafer and a discharge port configured to discharge dust generated by laser irradiation.

According to one embodiment, a laser irradiation method is a laser irradiation method performed using a laser irradiation apparatus configured to irradiate a wafer with laser light in order to form a back electrode of a compound semiconductor device, the laser irradiation method including: (A1) a step of generating laser light; and (A2) a step of irradiating the wafer with the laser light via a window that is disposed above the wafer, in which the laser irradiation apparatus includes: a stage configured to hold the wafer; a laser light source configured to generate the laser light; a chamber configured to accommodate the stage; a window unit that is provided in the chamber and includes the window through which the laser light transmits; a dust collector that is disposed immediately below the window unit and is provided with a supply port configured to supply gas toward the wafer and a discharge port configured to discharge dust generated by laser irradiation.

According to one embodiment, a method for manufacturing a compound semiconductor device is a method for manufacturing a compound semiconductor device for irradiating a wafer with laser light using a laser irradiation apparatus to form a back electrode, the method including: (S1) a step of generating laser light; and (S2) a step of irradiating the wafer with the laser light via a window that is disposed above the wafer, in which the laser irradiation apparatus includes: a stage configured to hold the wafer; a laser light source configured to generate the laser light; a chamber configured to accommodate the stage; a window unit that is provided in the chamber and includes a window through which the laser light transmits; and a dust collector that is disposed immediately below the window unit and is provided with a supply port configured to supply gas toward the wafer and a discharge port configured to discharge dust generated by laser irradiation.

### Advantageous Effects of Invention

According to one embodiment, it is possible to provide a laser irradiation apparatus, a laser irradiation method, and a method for manufacturing a compound semiconductor device capable of appropriately irradiating a substrate with laser light.

### Brief Description of Drawings

Fig. 1 is a cross-sectional side view schematically showing a laser irradiation apparatus;
Fig. 2 is a top view schematically showing a configuration in a chamber of the laser irradiation apparatus;
Fig. 3 is a top view schematically showing the laser irradiation apparatus;
Fig. 4 is a schematic view for describing an example of scanning laser light by stage driving;
Fig. 5 is a top view showing a configuration of a light-shielding plate;
Fig. 6 is a diagram for describing an operation of a stage unit;
Fig. 7 is a diagram for describing an operation of the stage unit;
Fig. 8 is a diagram showing a configuration of a dust collector;
Fig. 9 is a diagram showing a configuration of a distribution ring;
Fig. 10 is a cross-sectional view of a process showing a method for manufacturing a semiconductor device according to this embodiment; and
Fig. 11 is a cross-sectional view of the process showing the method for manufacturing the semiconductor device according to this embodiment.

### Description of Embodiments

A laser irradiation apparatus according to this embodiment is, for example, an excimer laser annealing apparatus (ELA apparatus) that uses excimer laser light. The ELA apparatus irradiates a substrate with laser light in order to form a back electrode of a compound semiconductor. The substrate is a wafer formed of a compound semiconductor. For example, a nickel film formed in a semiconductor wafer such as an SiC is irradiated with laser light. Accordingly, nickel is converted into silicide, whereby an ohmic contact layer is formed. Then, by forming a metal electrode on the ohmic contact layer of nickel silicide, a back electrode is formed. Hereinafter, with reference to the drawings, a laser irradiation apparatus, a laser irradiation method, and a manufacturing method according to this embodiment will be described.

The drawings described below show an XYZ three-dimensional orthogonal coordinate system as appropriate for the sake of clarification of the description. The Z direction, which is a vertical direction, is a direction perpendicular to a principal surface of the substrate. The XY-plane is a plane that is parallel to the principal surface of the substrate. The Z direction is a direction that is perpendicular to the vertical direction. Further, in the upper view, the Y direction is a direction that is parallel to a longitudinal direction of a line beam and the X direction is a perpendicular direction.

### (Overall Configuration)

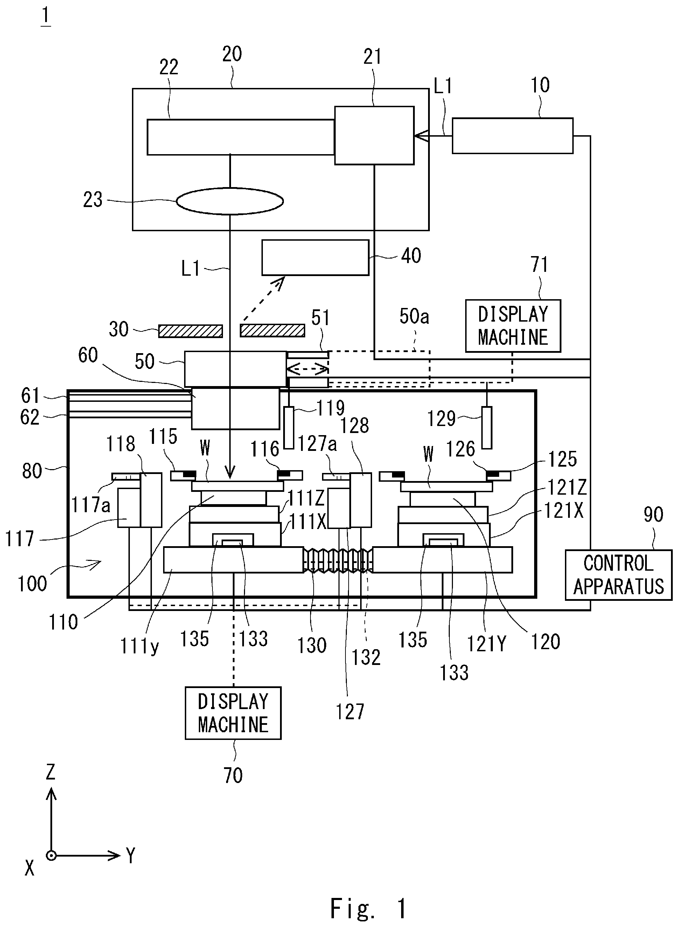

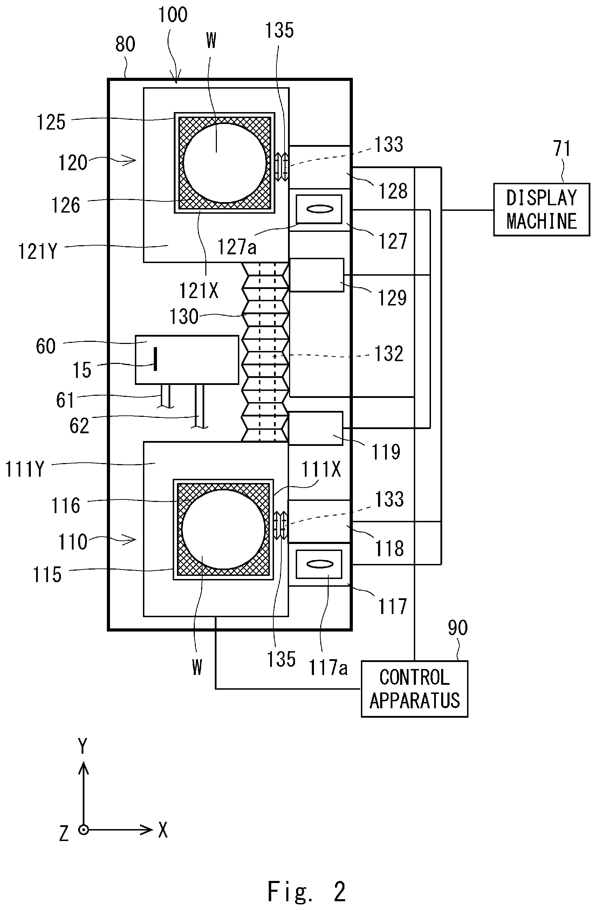

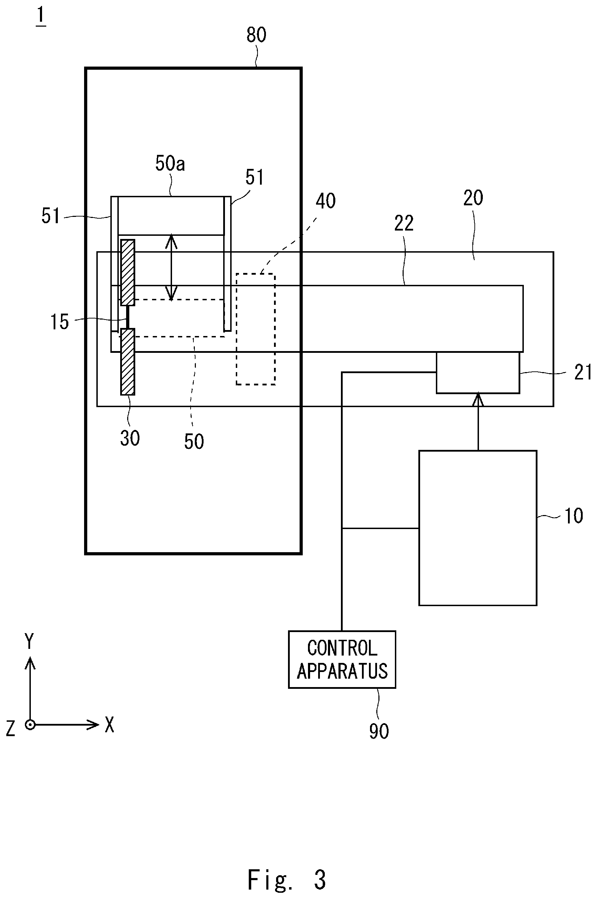

With reference to Fig. 1, a configuration of a laser irradiation apparatus according to this embodiment will be described. Fig. 1 is a cross-sectional side view schematically showing a configuration of a laser irradiation apparatus 1. Fig. 2 is a plan view showing a configuration in a chamber of the laser irradiation apparatus 1. Fig. 3 is a top view showing the configuration of the laser irradiation apparatus.

The laser irradiation apparatus 1 includes a laser light source 10, an optical system 20, a slit 30, a beam dumper 40, a window unit 50, a dust collector 60, display machines 70 and 71, a chamber 80, and a control apparatus 90. The chamber 80 accommodates a stage unit 100, and so on. The stage unit 100 includes two stages 110 and 120 to hold two respective substrates W.

The stage 110 and the stage 120 each hold the substrate W. Each of these stages 110 and 120 is an xyz stage for driving the substrate W. Therefore, as the stages 110 and 120 move, an irradiation position of the laser light with respect to the substrate W is scanned. A detailed configuration and operations of the stage unit 100 will be described later.

The laser light source 10, which is an excimer laser light source, generates a laser light L1. Here, the laser light L1 is pulse light having a center wavelength of 308 nm and a repetition frequency of 300 Hz. The laser light L1 is made incident on the optical system 20.

The optical system 20 includes a variable attenuator 21, a beam shaping unit 22, and a projection lens 23. The variable attenuator 21 functions as a pulse adjustment unit that adjusts a pulse intensity of the laser light L1. For example, the variable attenuator 21 adjusts a pulse intensity by attenuating the laser light. Further, the pulse waveform may be adjusted by using a pulse stretcher that extends the pulse length. The control apparatus 90 that will be described later can adjust the pulse waveform and the laser power of the laser light L1.

The laser light L1 from the variable attenuator 21 is made incident on the beam shaping unit 22. The beam shaping unit 22 shapes the cross-sectional profile shape of the laser light L1 on a plane that is perpendicular to the optical axis. The beam shaping unit 22 includes a homogenizer for homogenizing the laser light L1, a condenser lens that concentrates the laser light L1, and so on. As shown in Fig. 3, the laser light L1 forms a line-shaped irradiation region 15 on the substrate W. The irradiation region 15 has a line shape in which the Y direction is set as the longitudinal direction and the X direction is set as the lateral direction. That is, the beam shaping unit 22 shapes the laser light L1 into a line beam along the Y direction. Further, the beam shaping unit 22 shapes, for example, the profile of the laser light L1 into a top-flat distribution. The laser light L1 shaped by the beam shaping unit 22 is made incident on the projection lens 23.

The projection lens 23 includes a plurality of lenses for projecting the laser light L1 onto the substrate W. The projection lens 23 condenses the laser light L1 onto the substrate. On the substrate W, the laser light L1 forms a line-shaped irradiation region. The irradiation region sets the Y direction as the longitudinal direction and the X direction as the lateral direction. For example, the line length in the Y direction is 40 mm and the beam width in the X direction is 0.5 mm. Further, the laser light L1 exhibits the top-flat distribution. As a matter of course, the beam size is not limited to the aforementioned value. For example, the line length in the Y direction may be 10 mm or more.

The slit 30 is provided immediately below the optical system 20. The laser light L1 from the projection lens 23 is made incident on the slit 30. The slit 30 has an opening along the Y direction. The laser light L1 that has passed through the opening of the slit 30 is made incident on the window unit 50. The slit 30 may be a variable slit in order to change the beam size.

The beam dumper 40 is provided obliquely above the slit 30. The laser light L1 shielded by the slit 30 is made incident on the beam dumper 40. That is, a part of the laser light L1 reflected on the slit 30 is absorbed by the beam dumper 40. A cooling pipe or the like for circulating cooling water may be disposed in the beam dumper 40.

The laser light L1 from the slit 30 is made incident on the window unit 50. The window unit 50 is attached to the top of the chamber 80. That is, the window unit 50 is disposed outside the chamber 80. The window unit 50 includes a transparent window, a holder that holds the window, and so on. The laser light L1 transmits through the window of the window unit 50 and propagates within the chamber 80. The window unit 50 is disposed to be replaceable for maintenance purposes. The configuration of the window unit 50 will be described later.

The dust collector 60 is disposed immediately below the window unit 50. The dust collector 60 is disposed in the chamber 80. The dust collector 60 collects dust generated by laser irradiation. An air supply pipe 61 and an exhaust pipe 62 are connected to the dust collector 60. The configuration of the dust collector 60 will be described later. The laser light L1 that has passed through the dust collector 60 is made incident on the substrate W.

The substrate W is placed on each of the stages 110 and 120. The stages 110 and 120 are, for example, chuck stages that suck the substrates W. For example, suction holes or the like by which the substrate W is vacuum-suctioned are provided on the surface of each of the stages 110 and 120. Further, each of the stages 110 and 120 is a three-dimensional drive stage capable of moving in the xyz direction.

Therefore, the stage 110 includes an X drive mechanism 111X, a Y drive mechanism 111Y, and a Z drive mechanism 111Z. Likewise, the stage 120 includes an X drive mechanism 121X, a Y drive mechanism 121Y, and a Z drive mechanism 121Z. As the stages 110 and 120 each drive the substrate W, the position of the laser light L1 with respect to each of the substrates W moves. The stages 110 and 120 each move the substrate W in the xy directions, whereby the laser light L1 scans the substrate W. Accordingly, the whole surface of each of the substrates W is irradiated with the laser light L1. Further, the Z drive mechanisms 111Z and 121Z perform lifting/lowering operations in order to load and unload the substrate W. Since the operation and the configuration of the stage 110 and those of the stage 120 are similar to each other, the stage 110 will be mainly described in the following description.

A power monitor 117 and a beam profiler 118 are provided on the stage 110. The power monitor 117 and the beam profiler 118 move along with the stage 110. A power monitor 127 and a beam profiler 128 are provided on the stage 120. The power monitor 127 and the beam profiler 128 move along with the stage 120.

The power monitors 117 and 127 are photodetectors for measuring power of the laser light. Slit light-shieling plates 117a and 127a are provided on the incident side of the power monitors 117 and 127. The slit light-shieling plates 117a and 127a have long hole openings whose longitudinal direction corresponds to the Y direction. The power monitor 117 detects the laser light L1 that has passed through the slit light-shieling plate 117a. The power monitor 127 detects the laser light L1 that has passed through the slit light-shieling plate 127a. The power of the pulse laser light is thus detected. By using the power monitors 117 and 127, dirt on the window can be monitored.

The beam profilers 118 and 128, which are photodetectors having a plurality of pixels, each detect a beam profile of the laser light. The beam profilers 118 and 128 measure the beam size and a spatial distribution of the laser light. In this manner, the power monitors 117 and 127 and the beam profilers 118 and 128 are provided in the stages 110 and 120. The power monitors 117 and 127 and the beam profilers 118 and 128 detect the laser light L1, and output detection signals indicating results of the detection to the control apparatus 90. By using the beam profilers 118 and 128, dirt on the window can be monitored.

The control apparatus 90 feedback-controls the laser light source 10, the variable attenuator 21, or the beam shaping unit 22 based on results of the detection. It is therefore possible to adjust the power and the profile of the laser light L1 to those suitable for the irradiation process. For example, when the intensity of the laser light becomes low, the laser light source 10 and the variable attenuator 21 are controlled to increase the intensity of the laser light. It is therefore possible to perform irradiation of the laser light at an appropriate intensity. Further, the display machines 70 and 71 may display the results of detecting the beam profile and the laser power.

### (Stage Drive)

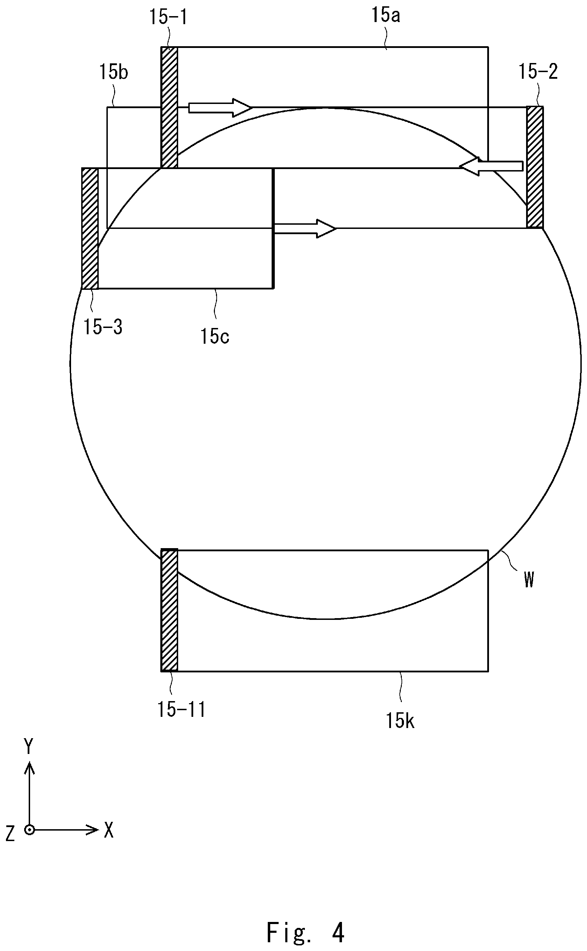

With refence to Fig. 4, scanning of the laser light L1 by the driving of the stages 110 and 120 will be described. Fig. 4 is an XY plan view for describing one example for scanning the laser light L1. As described above, the laser light L1 forms a line-shaped irradiation region whose longitudinal direction corresponds to the Y direction. The line length in the Y direction is 40 mm and the beam width in the X direction is 0.5 mm. Further, while the substrate W is circular in Fig. 4, orientation flats or notches may be formed therein.

In this example, the stage 110 moves in the XY directions in a zigzag pattern, whereby the whole surface of the substrate W is irradiated with the laser light L1. That is, the stage 110 moves in the X direction in a state in which the substrate W is irradiated with the line-shaped laser light L1 whose longitudinal direction corresponds to the Y direction. When the laser light L1 is scanned from one end of the substrate W to the other end of the substrate W, a strip region (e.g., region 15a) extending in the X direction is irradiated with the laser light L1. Then the stage 110 moves in the Y direction and the irradiation region 15 in the substrate W is shifted in the Y direction. The stage 110 repeats the movement in the X direction and the movement in the Y direction, whereby the whole surface of the substrate W is irradiated with the laser light.

The stage 110 moves the substrate W in the -X direction in a state in which an irradiation position 15-1 is irradiated with the laser light L1 in the Y direction. When the laser light L1 performs scanning from one end of the substrate W to the other end thereof, scanning for one line is ended. After the scanning of the first line is ended, a strip region 15a is the irradiated region. In the Y direction, almost half of the strip region 15a extends beyond the substrate W.

Next, the stage 110 moves in the +Y direction in the other end of the substrate W. In this example, the stage 110 moves in the +Y direction by half a pitch of the line length. Accordingly, in the Y direction, the substrate W is irradiated with the laser light L1 in such a way that an irradiation position 15-2 is irradiated with the laser light L1. In the state in which the irradiation position 15-2 is irradiated with the laser light L1, the stage 110 moves the substrate W in the +X direction. After the laser light L1 performs scanning from the other end of the substrate W to one end of the substrate W, scanning for one line is ended. After the scanning of the second line is ended, a strip region 15b is the irradiated region.

In the other end of the substrate W, the stage 110 moves in the +Y direction. In this example, the stage 110 moves in the +Y direction by half a pitch of the line length. Accordingly, in the Y direction, the substrate W is irradiated with the laser light L1 in such a way that an irradiation position 15-3 is irradiated with the laser light L1. After the stage 110 moves the substrate W in the -X direction in the state in which the irradiation position 15-2 is irradiated with the laser light L1, a strip region 15c is the irradiated region. In this manner, the stage 110 repeats movement in the X direction and the Y direction.

Then, in the Y direction, the substrate W is irradiated with the laser light L1 in such a way that an irradiation position 15-11 is irradiated with the laser light L1. The stage 110 moves the substrate W in the +X direction in a state in which the irradiation position 15-11 is irradiated with the laser light L1. After the laser light L1 performs scanning from the other end of the substrate W to one end thereof, scanning of the last line is ended. After the scanning of the last line is ended, a strip region 15k is the irradiated region. In the Y direction, almost half the strip region 15k extends beyond the substrate W. In this example, the substrate W is an 8-inch wafer and the line length is 40 mm. Therefore, the stage 110 scans 11 lines.

Here, in the Y direction, the stage 110 moves in such a way that adjacent irradiation positions overlap. Specifically, in the Y direction, the stage 110 moves in such a way that almost half the line length overlaps. Further, since the laser light L1 is pulse laser light, the stage 110 moves in such a way that the pulse laser light overlaps in the X direction as well. Specifically, the moving speed of the stage 110 in the X direction is determined according to the repetition frequency and the line width of the pulse laser light. In this example, the moving speed of the stage 110 is set in such a way that about 80% of irradiation regions overlap in two consecutive pulses in the X direction. As a matter of course, the line length, the line width, the scanning speed, the overlap amount, and the like of the laser light are not limited to the aforementioned values.

As shown in Fig. 1, the stage 110 includes the X drive mechanism 111X and the Y drive mechanism 111Y. The stage 120 includes the X drive mechanism 121X and the Y drive mechanism 121Y. The X drive mechanisms 111X and 121X reciprocate the substrate W in the X direction so that the laser light L1 scans the substrate W. The Y drive mechanisms 111Y and 121Y move the substrate W in the line direction of the laser light L1. Then the laser light L1 scans the substrate W in such a way that irradiation regions partially overlap in the adjacent scanning line. Accordingly, it is possible to evenly irradiate the substrate W with the laser light L1.

### (Light-shielding Plate)

Further, light-shielding plates 116 and 126 are respectively provided in the stages 110 and 120. The substrates W are disposed under the light-shielding plates 116 and 126. The light-shielding plates 116 and 126 each cover the peripheral part of the substrate W. The light-shielding plate 116 is attached to the stage 110 via a mount 115. Further, the light-shielding plate 126 is attached to the stage 120 via a mount 125.

The light-shielding plates 116 and 126 are made of materials that absorb or reflect the laser light L1. The light-shielding plates 116 and 126 are each formed of a metallic multi-layer reflective film or the like in such a way that the light-shielding plates 116 and 126 each reflect UV light having a wavelength of 308 nm. The mounts 115 and 125 are made of ceramic or the like. The mounts 115 and 125 are frame bodies for fixing the light-shielding plates 116 and 126.

As shown in Fig. 4, since the laser light L1 is a line beam, a region extending beyond the substrate W is also irradiated with the laser light L1. The light-shielding plate 116, which is disposed on the upper side of the substrate W, covers the peripheral part of the substrate W and the outside of the substrate W. By disposing the light-shielding plate 116, it is possible to prevent the upper surface of the stage 110 from being irradiated with the laser light L1. It is therefore possible to prevent the stage 110 from being damaged.

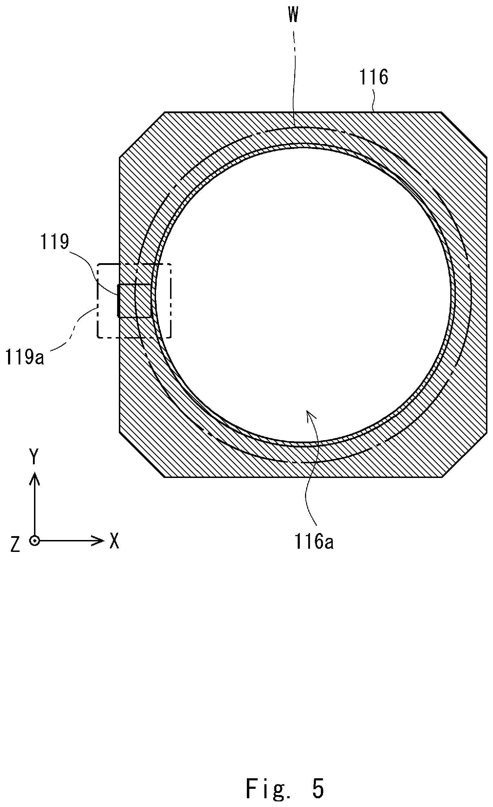

Fig. 5 is a top view showing a configuration of the light-shielding plate 116. The light-shielding plate 116 includes an opening 116a for enabling the laser light L1 to transmit therethrough. Therefore, the laser light L1 passes through the opening 116a and is irradiated onto the substrate W. The opening 116a is a circle that is slightly smaller than the outer diameter of the substrate W. Therefore, the peripheral part of the substrate W is covered with the light-shielding plate 116.

Further, as shown in Fig. 1, cameras 119 and 129 for alignment are installed above the stages 110 and 120. For example, the cameras 119 and 129 are disposed immediately above the stages 110 and 120 which are in the loading position of the substrate W. The cameras 119 and 129 are attached, for example, to the chamber 80. As shown in Fig. 5, a field of view 119a of the camera 119 includes the edge part of the substrate W. Further, the field of view 119a includes a boundary between the light-shielding plate 116 and the opening 116a. The camera 119 images the substrate W and the light-shielding plate 116 when the substrate W is loaded, whereby the position of the substrate W with respect to the light-shielding plate 116 can be detected. It is therefore possible to prevent misalignment when the substrate W is loaded.

The light-shielding plate 116 is preferably made of a material that transmits visible light. That is, the light-shielding plate 116 is made of a material with high reflectance for the laser wavelength of the laser light L1 and high transmittance to visible light. Accordingly, the camera 119 can image the edge of the substrate W beyond the light-shielding plate 116. It is sufficient that the camera 119 be fixed to the chamber 80 in such a way that the camera 119 is disposed over the light-shielding plate 116 in the loading position of the substrate W.

The camera 119 outputs the captured image to the control apparatus 90. The control apparatus 90 can measure a relative positional relationship between the light-shielding plate 116 and the substrate W. For example, the control apparatus 90 controls the loading position of the substrate W based on the image captured by the camera 119. This allows a substrate loading robot or the like to load the substrate W onto an appropriate position on the stage 110.

In this manner, the cameras 119 and 129 each detect a relative position of the substrate W with respect to the light-shielding plate 116. The stages 110 and 120 each align the substrate W based on the results of the detection by the camera 119. For example, loading positions may be adjusted by the X drive mechanisms 111X and 121X and the Y drive mechanisms 111Y and 121Y. Alternatively, the stages 110 and 120 may include alignment mechanisms for fine adjustment other than the X drive mechanisms 111X and 121X and the Y drive mechanisms 111Y and 121Y. The display machines 70 and 71 may display the results of imaging by the camera.

### (Stage Unit 100)

Further, in this embodiment, in order to efficiently irradiate the substrate W with the laser light, the stage unit 100 includes the two stages 110 and 120. While a substrate W is irradiated with the laser light L1 in one stage 110, another substrate W is loaded and unloaded in the other stage. It is therefore possible to reduce time waiting for loading and unloading of the substrates W. Therefore, takt time can be reduced, whereby productivity can be improved.

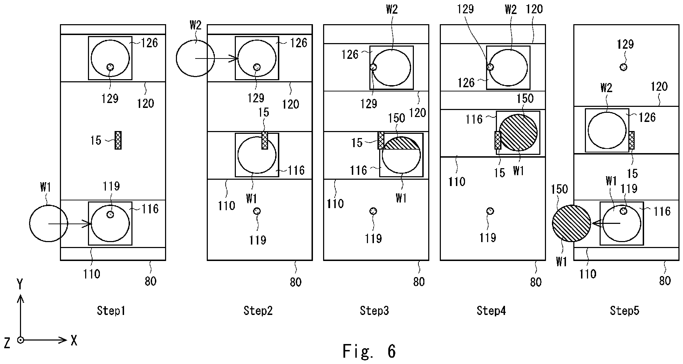

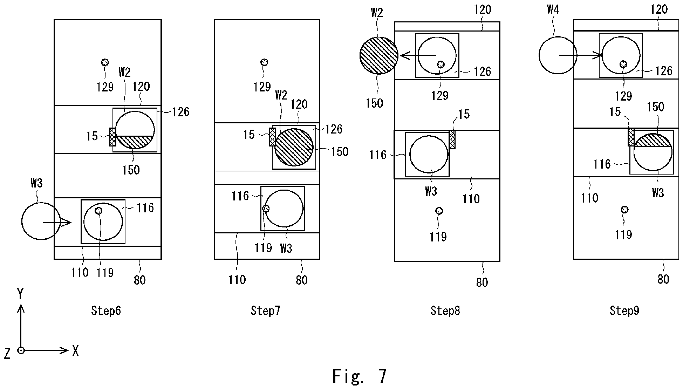

With reference to Figs. 6 and 7, operations of the stages 110 and 120 will be described in detail. Figs. 6 and 7 are diagrams for describing an operation of a twin stage. Note that Figs. 6 and 7 show top views schematically showing the stages 110 and 120, and components are simplified as appropriate. For example, the window unit 50 and so on are omitted. Further, in Figs. 6 and 7, substrates W placed on the stage 110 are denoted by substrates W1 and W3 and substrates W placed on the stage 120 are denoted by substrates W2 and W4.

Note that the substrate W1 is a substrate that is irradiated with laser first by the stage 110, and W3 is a substrate that is irradiated with laser next to the substrate W1 by the stage 110. The substrate W2 is a substrate that is irradiated with laser first by the stage 120, and W3 is a substrate that is irradiated with laser next to the substrate W2 by the stage 120. The laser irradiation process is performed in the order of the substrates W1, W2, W3, and W4.

The substrate W1 is loaded onto the stage 110 (step 1). For example, the Z drive mechanism 111Z of the stage 110 raises or lowers a placement surface of the stage 110, whereby the substrate W1 can be received from a substrate loading robot. In this example, the stages 110 and 120 are in the loading/unloading position of the substrate. While the description is made assuming that the loading position and the unloading position are the same in this example, they may be different from each other. The loading/unloading position is deviated from the irradiation region 15 in the Y direction. Specifically, the loading/unloading position of the stage 110 is on the -Y side of the irradiation region 15. The loading/unloading position of the stage 120 is on the +Y side of the irradiation region 15. Further, a robot hand or the like moves the substrate W1 in the +X direction from the outside of the chamber 80, whereby the substrate W1 is loaded onto the stage 110. At this time, the camera 119 may image the edge of the substrate W1 to perform alignment.

After the substrate W1 is loaded onto the stage 110, the stage 110 drives in the +Y direction, whereby the substrate W1 moves to the irradiation region 15 of the laser light L1 (step 2). Further, in this step, the substrate W2 is loaded onto the stage 120. That is, the movement of the stage 110 and the loading of the substrate W2 are performed in parallel to each other. In this manner, the substrate W2 is loaded onto the stage 120 while the stage 110 is moving.

Then, the stage 110 drives in the XY directions, whereby the substrate W1 is irradiated with the laser light L1 (step 3). Accordingly, a part of the substrate W1 is the irradiated region 150. As described above, the stage 110 moves the substrate W1 in a zigzag pattern. As a matter of course, the stage 110 may scan the substrate W1 by raster scanning or the like. At this time, the stage 120 waits at the loading/unloading position. Then, after the scanning by the stage 110 is ended, substantially the whole surface of the substrate W1 is irradiated with the laser light L1. Accordingly, substantially the whole surface of the substrate W1 is the irradiated region 150 (step 4). Further, as described above, the camera 129 for alignment may image the edge of the substrate W2 to perform alignment.

After the laser irradiation process on the substrate W1 is ended, the stage 110 moves in the -Y direction. The stage 110 is retracted to the loading/unloading position to unload the substrate W1 (step 5). At this time, the stage 120 moves in the -Y direction. Therefore, the stage 120 moves to the irradiation region 15 of the laser light L1. In this manner, the operation of unloading the substrate W1 and the movement of the stage 120 are concurrently performed.

Then, the stage 120 drives in the XY directions, whereby the substrate W2 is irradiated with the laser light L1 (step 6). Accordingly, a part of the substrate W2 is the irradiated region 150. As described above, the stage 120 moves the substrate W2 in a zigzag pattern. As a matter of course, the stage 120 may scan the substrate W2 by raster scanning or the like. At this time, the stage 110 is in the loading/unloading position, and an operation of loading the next substrate W3 is performed. After the scanning by the stage 120 is ended, substantially the whole surface of the substrate W2 is irradiated with the laser light L1 (step 7). Accordingly, substantially the whole surface of the substrate W2 is the irradiated region 150. Further, the camera 119 may image the edge of the substrate W3 to perform alignment.

After the laser irradiation process on the substrate W2 is ended, the stage 120 moves in the +Y direction. That is, the stage 120 is retracted to the loading/unloading position and unloads the substrate W2 (step 8). At this time, the stage 110 moves in the +Y direction. Therefore, the stage 110 moves to the irradiation region 15 of the laser light L1. In this manner, the operation of unloading the substrate W2 and the movement of the stage 110 are concurrently performed.

Then, the stage 110 drives in the XY directions, whereby the substrate W3 is irradiated with the laser light L1 (step 9). Accordingly, a part of the substrate W3 is the irradiated region 150. Similarly to the above description, the stage 110 moves the substrate W1 in a zigzag pattern. At this time, the next substrate W4 is loaded onto the stage 120 at the loading/unloading position. In this manner, the operation of loading the substrate W4 and the movement of the stage 110 are concurrently performed.

In this manner, the control apparatus 90 controls the stage unit 100 in such a way that the stage 110 and the stage 120 alternately perform the laser irradiation process. While one of the stages 110 and 120 performs the loading/unloading operation, the other one of the stages 110 and 120 moves. For example, while the substrate W3 is being loaded onto the stage 110 or the substrate W1 is being unloaded from the stage 110, the stage 120 is driven and the substrate W2 is irradiated with laser light. Further, while the substrate W4 is being loaded onto the stage 120 or the substrate W2 is being unloaded from the stage 120, the stage 110 is driven and the substrate W3 is irradiated with the laser light L1. Accordingly, the standby time can be reduced, whereby productivity can be improved.

### (Cover of Guide Mechanism)

The stages 110 and 120 are xyz-drive stages. Therefore, the stages 110 and 120 are slid in the x direction and the y direction, which enables the substrates W to move. It is possible that dust generated when the stages 110 and 120 are slid may affect the laser irradiation process. When the laser irradiation process is performed in a state in which dust is adhered to the substrate W or the window of the window unit, a part of the laser light is absorbed or reflected by dust. In this case, it is possible that alloying (silicide formation) may not occur properly. In order to deal with this problem, in this embodiment, a cover is provided in the guide mechanism in order to reduce dust.

For example, as shown in Fig. 1, the Y drive mechanisms 111Y and 121Y include a guide mechanism 132. The guide mechanism 132 is, for example, a guide rail or the like, and is disposed along the Y direction. The guide mechanism 132 guides the movement of the stages 110 and 120 in the Y direction. Movable parts of the Y drive mechanisms 111Y and 121Y move along the guide mechanism 132. The guide mechanism 132 is covered with a cover 130. The cover 130 has, for example, an expandable bellows structure.

For example, one end of the cover 130 is attached to an end of the guide mechanism 132 and the other end thereof is attached to the movable part. Therefore, the cover 130 expands and contracts in accordance with the movement of the movable part. It is possible to prevent dust generated by sliding of the guide mechanism 132 and the movable parts of the Y drive mechanisms 111Y and 121Y from floating in the chamber 80. It is therefore possible to prevent dust from adhering to the surface of the substrate W.

Likewise, the X drive mechanisms 111X and 121X include a guide mechanism 133. The guide mechanism 133 guides the movement of the stages 110 and 120 in the X direction. The guide mechanism 133 is covered with a cover 135. The guide mechanism 133 is, for example, a guide rail or the like, and is disposed along the X direction. The cover 135 has, for example, an expandable bellows structure.

For example, one end of the cover 135 is attached to the guide mechanism 132, and the other end of the cover 135 is attached to the movable part. Therefore, the cover 130 expands and contracts in accordance with the driving of the X drive mechanisms 111X and 121X. It is therefore possible to prevent dust generated by sliding of the guide mechanism 133 and the movable parts of the X drive mechanisms 111X and 121X from floating in the chamber 80. It is therefore possible to prevent dust from adhering to the surface of the substrate W.

As described above, the laser irradiation apparatus 1 includes the covers 130 and 135. Since the covers 130 and 135 cover the guide mechanisms 132 and 133, it is possible to prevent dust from scattering, whereby it becomes possible to stably perform the laser irradiation process.

### (Window Unit 50)

The window unit 50 is provided to be replaceable for maintenance purposes. If the window of the window unit 50 becomes dirty, the entire window unit 50 can be replaced with another one. As shown in Fig. 3, the window unit 50 is disposed immediately below the slit 30 and the optical system 20. Since there is no sufficient space immediately below the optical system 20, it becomes difficult to conduct the replacement work. Therefore, in this embodiment, the window unit 50 is disposed so as to be movable to a replacement position.

Specifically, the window unit 50 is attached to a replacement rail 51. The replacement rail 51 is a mechanism for replacing the window unit 50 by another one. The replacement rail 51 is a guide mechanism provided along the Y direction. The replacement rail 51 extends along the Y direction, and is attached to the upper surface of the chamber 80. The window unit 50 moves in the Y direction along the replacement rail 51.

The window unit 50 moves to the replacement position (position of a window unit 50a). This causes the window unit 50 to be displaced from the position immediately below the optical system 20 and the slit 30. It is therefore possible to easily perform the replacement work of the window unit 50. At the time of the laser irradiation process, a cylinder or the like pushes the window unit 50 toward the chamber 80. At the time of maintenance, the pressure applied by the cylinder is released.

As described above, the window unit 50 moves in the Y direction along the replacement rail 51. Therefore, the window unit 50 can be retracted from the position immediately below the optical system 20. Since it is possible to secure the working space for replacement, the worker can efficiently perform the replacement work. Accordingly, the maintenance time can be reduced, whereby productivity can be improved.

### (Dust Collector)

When dust is generated in the chamber 80, this may affect the laser irradiation process. For example, it is possible that, as a result of laser irradiation, a metal material such as a nickel film disposed in the substrate W may evaporate and turn into dust. When the dust is adhered to the window, it affects the laser irradiation process. In order to deal with this problem, in this embodiment, as shown in Fig. 2 and so on, the dust collector 60 is provided near the irradiation region 15. As shown in Fig. 1, the dust collector 60 is disposed immediately below the window unit 50. That is, the dust collector 60 is disposed immediately above the irradiation region 15. The dust collector 60 collects dust such as metal that is generated from the substrate W by laser irradiation.

As shown in Figs. 1 and 2, the air supply pipe 61 and the exhaust pipe 62 are connected to the dust collector 60. The air supply pipe 61 and the exhaust pipe 62 are pipes extending to the outside of the chamber 80. The air supply pipe 61 is connected to a gas cylinder or the like located outside the chamber 80. Then gas from the gas cylinder or the like passes through the air supply pipe 61 and is supplied to the dust collector 60. The exhaust pipe 62 is connected to an exhaust pump or the like which is outside the chamber 80. Then, the gas in the dust collector 60 passes through the exhaust pipe 62 and is discharged outside the chamber 80.

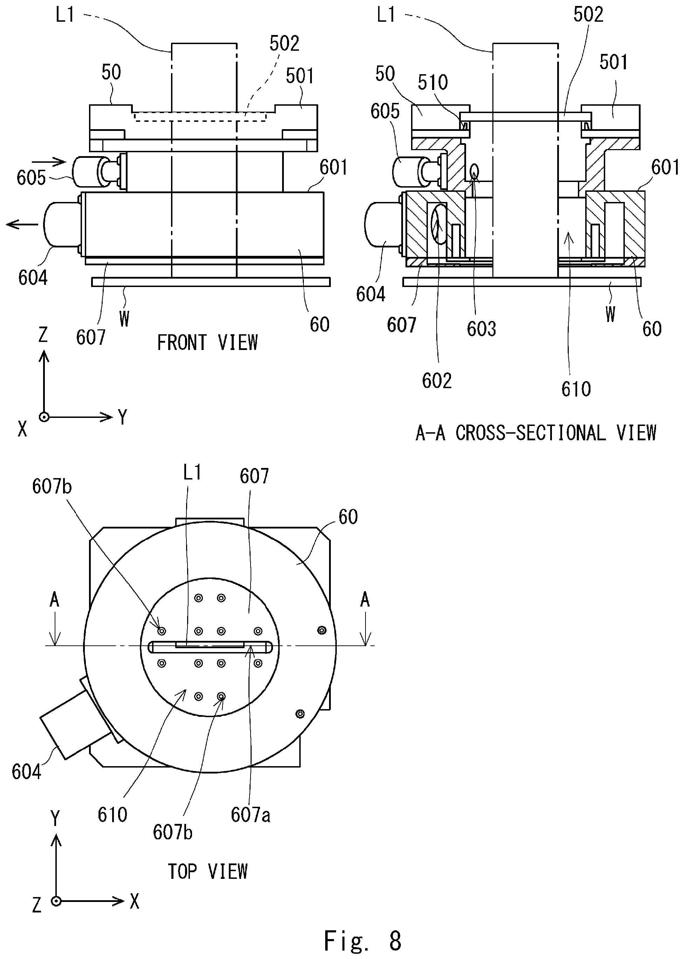

With reference to Fig. 8, a configuration of the dust collector 60 will be described in detail. Fig. 8 shows a front view, a top view, and a cross-sectional view of the dust collector 60. Further, in the cross-sectional view and the front view in Fig. 8, the window unit 50 is also shown along with the dust collector 60. The window unit 50 is disposed on the dust collector 60.

The dust collector 60 includes a case 601 and a conductance ring 607. The case 601 is hollow. A cylindrical space 610 is formed inside the case 601. The laser light L1 passes through the space 610 and is made incident on the substrate W. A discharge port 602 and a supply port 603 are formed on the inner peripheral side surface of the case 601. The discharge port 602 and the supply port 603 penetrate through the case 601 in such a manner that the discharge port 602 and the supply port 603 face the space 610.

The window unit 50 includes a holder 501 and a window 502. The window 502 is a transparent disc formed of resin or glass. The laser light L1 transmits through the window 502. The holder 501 holds the window 502. The space 610 is arranged immediately below the window 502. The laser light L1 is irradiated onto the substrate W through the window 502 disposed above the substrate W.

Further, joints 604 and 605 are connected to the outer peripheral side surface of the case 601. The discharge port 602 is connected to the joint 604. The exhaust pipe 62 shown in Fig. 1 and so on is connected to the joint 604. The exhaust pipe 62 can discharge the air in the space 610 from the discharge port 602 to the outside. In this manner, the discharge port 602 is disposed to discharge the dust generated by laser irradiation.

The supply port 603 is connected to the joint 605. The air supply pipe 61 shown in Fig. 1 and so on is connected to the joint 605. The air supply pipe 61 can supply gas from the supply port 603 to the space 610. Specifically, clean gas such as air or nitrogen is ejected from the supply port 603 to the space 610. The supply port 603 can supply gas toward the substrate W.

Further, the discharge port 602 and the supply port 603 are disposed above the substrate W. The supply port 603 is disposed above the discharge port 602. The gas ejected from the supply port 603 flows downward and is discharged from the discharge port 602. Therefore, gas flows downward in the space 610, whereby it is possible to prevent evaporated metal materials from sticking to the window. That is, since the supply port 603 occurs the down flow, evaporated metal materials flow downward and are discharged from the discharge port 602. It is therefore possible to prevent metal dust from adhering to the window 502 and the like.

Further, the conductance ring 607 is provided on the lower surface of the case 601. The conductance ring 607 is a plate that is disposed to be opposed to the substrate W. The conductance ring 607 is fixed to the case 601 by bolts, or the like. An opening 607a for allowing the laser light L1 to pass therethrough is provided at the center of the conductance ring 607. The opening 607a is a slit opening having a longitudinal direction. The laser light L1 passes through the opening 607a and is irradiated onto the substrate W.

Further, in order to define the conductance between the substrate W and the dust collector 60, the conductance ring 607 includes a plurality of trap openings 607b. That is, by changing the number, the size, and the shape of the trap openings 607b, the conductance can be adjusted. For example, a plurality of conductance rings 607 having different numbers, sizes, and shapes of the trap openings 607b are prepared in advance. Then, the conductance ring 607 is attached to the case 601 so as to achieve a desired conductance. Accordingly, it is possible to control a flow of the gas on the upper side of the substrate W.

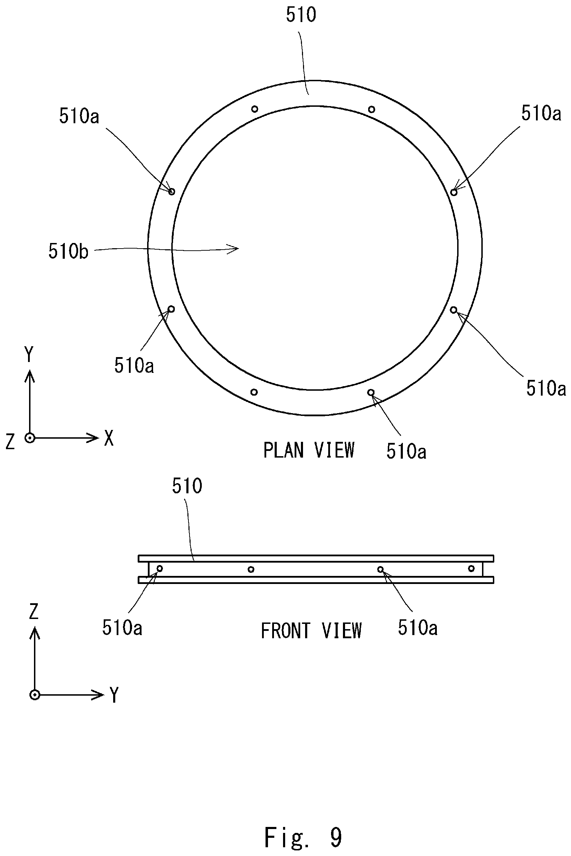

Further, as shown in the cross-sectional view in Fig. 8, a distribution ring 510 is provided below the window 502. With reference to Fig. 9, a configuration of the distribution ring 510 will be described in detail.

Fig. 9 is a plan view and a front view of the distribution ring 510. The distribution ring 510 is formed in a circular shape having a hollow part 510b. The hollow part 510b is positioned immediately above the space 610. A plurality of gas venting holes 510a are provided in the distribution ring 510. The gas venting holes 510a are formed on the inner peripheral side of the distribution ring 510. Further, the gas venting holes 510a may be disposed on an upper surface side (window side) of the distribution ring 510. The gas venting holes 510a are aligned along the circumferential direction. The plurality of gas venting holes 510a are connected together inside the distribution ring 510.

The distribution ring 510 is also connected to the air supply pipe 61. Therefore, gas is ejected from the gas venting hole 510a. The gas ejected from the gas venting hole 510a passes through the hollow part 510b and flows through the space 610.

A down flow is formed in the space 610 by the gas ejected by the distribution ring 510. It is therefore possible to prevent evaporated metal from adhering to the window 502.

Note that the laser irradiation apparatus may not include all the aforementioned components. That is, some of the components of the laser irradiation apparatus 1 may be omitted. For example, a laser irradiation apparatus according to one aspect of this embodiment includes: a stage configured to hold a wafer; a laser light source configured to generate the laser light; a chamber configured to accommodate the stage; a window unit that is provided in the chamber and includes a window through which the laser light transmits; and a dust collector that is disposed immediately below the window unit and is provided with a supply port configured to supply gas toward the wafer and a discharge port configured to discharge dust generated by laser irradiation.

Each of the aforementioned components may be added to this laser irradiation apparatus.

Note that a laser irradiation method according to another aspect of this embodiment includes the following steps from (A1) and (A2).

A laser irradiation method performed using a laser irradiation apparatus configured to irradiate a wafer with laser light in order to form a back electrode of a compound semiconductor device includes (A1) a step of generating laser light and (A2) a step of irradiating the wafer with the laser light via a window that is disposed above the wafer. Then the laser irradiation apparatus includes: a stage configured to hold the wafer; a laser light source configured to generate the laser light; a chamber configured to accommodate the stage; a window unit that is provided in the chamber and includes the window through which the laser light transmits; and a dust collector that is disposed immediately below the window unit and is provided with a supply port configured to supply gas toward the wafer and a discharge port configured to discharge dust generated by laser irradiation.

Processing by each of the aforementioned components may be added to this laser irradiation method.

The above laser irradiation method can be applied to a method for manufacturing a compound semiconductor device. The laser irradiation apparatus 1 is used for the process of forming the back electrode of the semiconductor device. For example, the laser irradiation apparatus 1 irradiates a wafer formed of a compound semiconductor with laser light. Accordingly, it is possible to form the back electrode of the semiconductor device formed on the wafer.

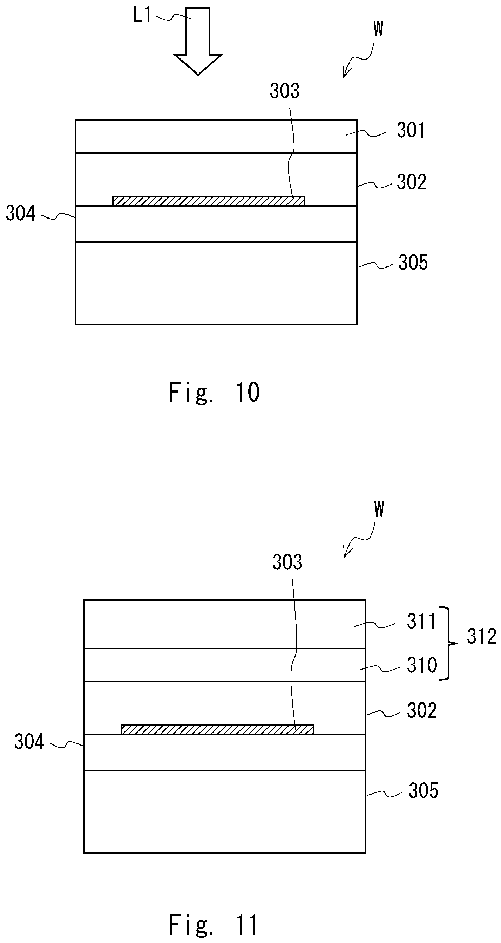

With reference to Figs. 10 and 11, a method for manufacturing the compound semiconductor device will be described. Fig. 10 is a cross-sectional view of a process showing a manufacturing process. Figs. 10 and 11 schematically show a configuration in the laser irradiation process.

The substrate W includes a metal film 301, a wafer 302, a semiconductor device 303, adhesive 304, and a glass substrate 305. The wafer 302 is a semiconductor wafer formed of a compound semiconductor such as silicon carbide (SiC). The wafer 302 includes a semiconductor device 303 such as a transistor. The semiconductor device 303 is an SiC power device. A metal film 301 is formed on the back surface of the wafer 302. Further, after the device is formed, the wafer 302 may be thinned through grinding, polishing, or the like.

The glass substrate 305 is bonded to the front surface side of the wafer 302 via the adhesive 304. The metal film 301 is, for example, a nickel film. As a matter of course, the metal film 301 may be formed of molybdenum (Mo), titanium (Ti), or tungsten (W) other than nickel (Ni). Further, the metal film 301 may be an alloy film including the above metal materials.

The laser irradiation apparatus 1 irradiates the metal film 301 with the laser light L1. Accordingly, the metal film 301 is made silicide and an ohmic contact layer 310 is formed (see Fig. 11). The ohmic contact layer 310 may be thinned by polishing, etching, or the like. Then, a metal film 311 is formed on the ohmic contact layer 310, whereby a back electrode 312 is formed. Since the metal film 301 is a nickel film, the ohmic contact layer 310 is a nickel silicide film. Further, the metal film 311 is titanium (Ti), aluminum (Al), silver (Ag), gold (Au), or the like, and may have a laminated structure thereof.

In this embodiment, the laser light L1 is excimer laser light having a wavelength of 308 nm. Therefore, the light absorption rate in nickel is higher than that of solid-state laser having a wavelength of 532 nm. Therefore, the metal film 301 can be efficiently annealed, which causes throughput to be improved. Further, in the excimer laser light, the pulse width can be made shorter than that in the solid-state laser having a wavelength of 532 nm. It is therefore possible to prevent a damage to the semiconductor device 303. It is possible to suppress the temperature increase of the adhesive 304, and so on. Therefore, it is possible to appropriately perform irradiation of laser light, whereby productivity can be improved.

Note that the present invention is not limited to the above embodiment, and may be changed as appropriate without departing from the spirit of the present invention.

### Reference Signs List

- 1: LASER IRRADIATION APPARATUS
- 10: LASER LIGHT SOURCE
- 15: IRRADIATION REGION
- 20: OPTICAL SYSTEM
- 21: VARIABLE ATTENUATOR
- 22: BEAM SHAPING UNIT
- 23: PROJECTION LENS
- 30: SLIT
- 40: BEAM DUMPER
- 50: WINDOW UNIT
- 60: DUST COLLECTOR
- 61: AIR SUPPLY PIPE
- 62: EXHAUST PIPE
- 70: DISPLAY MACHINE
- 71: DISPLAY MACHINE
- 80: CHAMBER
- 90: CONTROL APPARATUS
- 100: STAGE UNIT
- 110: STAGE
- 111X: X DRIVE MECHANISM
- 111Y: Y DRIVE MECHANISM
- 111Z: Z DRIVE MECHANISM
- 115: MOUNT
- 116: LIGHT-SHIELDING PLATE
- 117: POWER MONITOR
- 117a: SLIT LIGHT-SHIELING PLATE
- 118: BEAM PROFILER
- 119: CAMERA
- 120: STAGE
- 121X: X DRIVE MECHANISM
- 121Y: Y DRIVE MECHANISM
- 121Z: Z DRIVE MECHANISM
- 125: MOUNT
- 126: LIGHT-SHIELDING PLATE
- 127: POWER MONITOR
- 127a: SLIT LIGHT-SHIELING PLATE
- 128: BEAM PROFILER
- 129: CAMERA
- 130: COVER
- 132: GUIDE MECHANISM
- 133: GUIDE MECHANISM
- 135: COVER
- 301: METAL FILM
- 302: WAFER
- 303: SEMICONDUCTOR DEVICE
- 304: ADHESIVE
- 305: GLASS SUBSTRATE
- 310: OHMIC CONTACT LAYER
- 311: METAL FILM
- 312: BACK ELECTRODE
- 501: HOLDER
- 502: WINDOW
- 510: DISTRIBUTION RING
- 510a: GAS VENTING HOLE
- 510b: HOLLOW PART
- 601: CASE
- 602: DISCHARGE PORT
- 603: SUPPLY PORT
- 604: JOINT
- 605: JOINT
- 607: CONDUCTANCE RING
- 610: SPACE

## Claims

1. A laser irradiation apparatus configured to perform irradiation of laser light in order to form a back electrode of a semiconductor device formed on a wafer formed of a compound semiconductor, the laser irradiation apparatus comprising:
a stage configured to hold the wafer;
a laser light source configured to generate the laser light;
a chamber configured to accommodate the stage;
a window unit that is provided in the chamber and includes a window through which the laser light transmits; and
a dust collector that is disposed immediately below the window unit and is provided with a supply port configured to supply gas toward the wafer and a discharge port configured to discharge dust generated by laser irradiation.

2. The laser irradiation apparatus according to claim 1, wherein
the window unit further includes a distribution ring disposed above the supply port, and
the distribution ring is provided with a plurality of gas venting holes on an inner peripheral side and a window side thereof.

3. The laser irradiation apparatus according to claim 1 or 2, wherein
a conductance ring configured to define conductance between the dust collector and the wafer is further provided on a lower surface of the dust collector, and
the laser light passes through an opening that is provided at a center of the conductance ring and is irradiated onto the wafer.

4. The laser irradiation apparatus according to claim 3, wherein
the opening of the conductance ring is a slit opening having a longitudinal direction, and
the laser light that is shaped in a line passes through the slit opening and is irradiated onto the wafer.

5. The laser irradiation apparatus according to claim 1 or 2, wherein a window replacement mechanism configured to guide movement of the window unit is disposed in the chamber.

6. The laser irradiation apparatus according to claim 1 or 2, wherein a stage that holds the wafer moves, which causes the laser light to scan the wafer.

7. A laser irradiation method for performing irradiation of laser light using a laser irradiation apparatus in order to form a back electrode of a semiconductor device formed on a wafer formed of a compound semiconductor, the laser irradiation method comprising:
(A1) a step of generating laser light; and
(A2) a step of irradiating the wafer with the laser light via a window that is disposed above the wafer,
wherein the laser irradiation apparatus comprises:
a stage configured to hold the wafer;
a laser light source configured to generate the laser light;
a chamber configured to accommodate the stage;
a window unit that is provided in the chamber and includes the window through which the laser light transmits;
a dust collector that is disposed immediately below the window unit and is provided with a supply port configured to supply gas toward the wafer and a discharge port configured to discharge dust generated by laser irradiation.

8. The laser irradiation method according to claim 7, wherein
the window unit further includes a distribution ring disposed above the supply port, and
the distribution ring is provided with a plurality of gas venting holes on an inner peripheral side and a window side thereof.

9. The laser irradiation method according to claim 7 or 8, wherein
a conductance ring configured to define conductance between the dust collector and the wafer is further provided on a lower surface of the dust collector, and
the laser light passes through an opening that is provided at a center of the conductance ring and is irradiated onto the wafer.

10. The laser irradiation method according to claim 9, wherein
the opening of the conductance ring is a slit opening having a longitudinal direction, and
the laser light that is shaped in a line passes through the slit opening and is irradiated onto the wafer.

11. The laser irradiation method according to claim 7 or 8, wherein a window replacement mechanism configured to guide movement of the window unit is disposed in the chamber.

12. The laser irradiation method according to claim 7 or 8, wherein, in the step (A2), a stage that holds the wafer moves, which causes the laser light to scan the wafer.

13. A method for manufacturing a compound semiconductor device for performing irradiation of laser light using a laser irradiation apparatus in order to form a back electrode of a semiconductor device formed on a wafer formed of a compound semiconductor, the method comprising:
(S1) a step of generating laser light; and
(S2) a step of irradiating the wafer with the laser light via a window that is disposed above the wafer,
wherein the laser irradiation apparatus comprises:
a stage configured to hold the wafer;
a laser light source configured to generate the laser light;
a chamber configured to accommodate the stage;
a window unit that is provided in the chamber and includes a window through which the laser light transmits; and
a dust collector that is disposed immediately below the window unit and is provided with a supply port configured to supply gas toward the wafer and a discharge port configured to discharge dust generated by laser irradiation.

14. The method for manufacturing the compound semiconductor device according to claim 13, wherein
the window unit further includes a distribution ring disposed above the supply port, and
the distribution ring is provided with a plurality of gas venting holes on an inner peripheral side and a window side thereof.

15. The method for manufacturing the compound semiconductor device according to claim 13 or 14, wherein
a conductance ring configured to define conductance between the dust collector and the wafer is further provided on a lower surface of the dust collector, and
the laser light passes through an opening that is provided at a center of the conductance ring and is irradiated onto the wafer.

16. The method for manufacturing the compound semiconductor device according to claim 15, wherein
the opening of the conductance ring is a slit opening having a longitudinal direction, and
the laser light that is shaped in a line transmits through the slit opening and is irradiated onto the wafer.

17. The method for manufacturing the compound semiconductor device according to claim 13 or 14, wherein a window replacement mechanism configured to guide movement of the window unit is disposed in the chamber.

18. The method for manufacturing the compound semiconductor device according to claim 13 or 14, wherein, in the step (S2), a stage that holds the wafer moves, which causes the laser light to scan the wafer.
